# DEMANDE DE BREVET EUROPEEN

(11) **EP 4 447 131 A1**
(43) Date de publication de la demande: **16.10.2024**
(21) Numéro de dépôt: 24170298.4
(22) Date de dépôt: 15.04.2024
(51) Int. Cl.: H01L 31/05, H01L 31/18

(54) **PROCÉDÉS DE FABRICATION D'UNE CHAÎNE DE CELLULES PHOTOVOLTAÏQUES ÉLECTRIQUEMENT INTERCONNECTÉES ET D'UN MODULE PHOTOVOLTAÏQUE COMPRENANT UNE TELLE CHAÎNE**

(30) Priorité: 13.04.2023 FR 2303651
(71) Demandeur: Commissariat à l'énergie atomique et aux énergies alternatives, 75015 Paris (FR)
(72) Inventeur: HLADYS, Bertrand, 38054 GRENOBLE Cedex 09 (FR); LUCAS, Corentin, 38054 GRENOBLE Cedex 09 (FR); MONNA, Rémi, 38054 GRENOBLE Cedex 09 (FR)
(74) Mandataire: Hautier IP

(57) **Abrégé**

Procédé de fabrication d'une chaîne d'au moins deux cellules (C1, C2) photovoltaïques électriquement interconnectées, comprenant : une fourniture d'une courroie de transport et une élaboration d'une chaîne d'au moins deux cellules photovoltaïques (C1, C2), comprenant :un placement des première et deuxième cellules (C1, C2) sur la courroie de transport ; un dépôt d'au moins un élément d'interconnexion (2, 3, 30), un déploiement d'au moins un élément adhésif (20, 21, 40, 41) selon une direction secondaire inclinée par rapport à une direction principale ; une découpe dudit au moins un élément adhésif ; une mise en contact dudit au moins un élément adhésif (20, 21, 40, 41) avec ledit au moins un élément d'interconnexion (2, 3, 30) et la cellule (C1, C2) ; et un collage dudit au moins un élément adhésif sur ledit au moins un élément d'interconnexion (2, 3, 30) et la cellule (C1, C2).

## Description

### DOMAINE TECHNIQUE

La présente invention concerne la fabrication des modules photovoltaïques et des chaînes de cellules photovoltaïques. Elle concerne en particulier une chaîne de cellules photovoltaïques électriquement interconnectées.

### ETAT DE LA TECHNIQUE

Les modules photovoltaïques comportent plusieurs cellules photovoltaïques interconnectées entre elles pour former une chaîne appelée également chaîne photovoltaïque. L'interconnexion des cellules est un enjeu majeur car elle définit les caractéristiques de production d'énergie électrique des modules, notamment en termes de puissance électrique. Il existe différentes méthodes pour interconnecter des cellules photovoltaïques.

On peut citer un procédé dans lequel des cellules sont interconnectées entre elles par une brasure de fils de cuivre étamés aux bus de collecte des cellules. Les bus de collecte, appelés également « busbars » en langue anglaise, sont des éléments électriquement conducteurs placés au contact du substrat de la cellule et connectés aux électrodes de la cellule. Les électrodes habituellement appelées « doigts de collecte » ont pour rôle de collecter les porteurs de charge photo-générés par la cellule pour produire un courant électrique. En particulier, les bus de collecte s'étendent le long de la cellule et perpendiculairement aux doigts de collecte. La brasure consiste à souder les fils de cuivre étamés aux bus de collecte, par une étape effectuée à haute température (220 à 260°C). De façon générale, une brasure s'obtient par fusion d'un métal d'apport sans fusion du métal de base. Le point de fusion du métal d'apport doit donc être à une température inférieure à celle du métal de base. On entend par « étamés », le fait que les fils de cuivre comprennent un revêtement d'un alliage métallique servant comme un apport de métal pour réaliser la brasure. Mais ce procédé nécessite de former des plots de métallisation en argent sur les bus de collecte, afin de faciliter la brasure entre la cellule et les fils de cuivre étamés. Par ailleurs, dans le cas des cellules à hétérojonction, les fils de cuivre doivent être recouverts d'un alliage métallique ayant une basse température de fusion, par exemple à base de Pb ou de Bi, afin de ne pas dégrader les performances des cellules. Les cellules à hétérojonction sont des cellules comprenant un substrat de type cristallin et de type amorphe, le substrat pouvant être à base de silicium ou de pérovskite. En outre, un tel procédé nécessite une grande quantité d'argent au niveau de la métallisation de la cellule, ce qui rend le procédé de fabrication très coûteux.

On peut citer par exemple, un procédé d'interconnexion entre deux cellules photovoltaïques à l'aide d'une colle électriquement conductrice positionnée le long des bus de collecte des cellules. L'interconnexion de deux cellules consiste à positionner un fil conducteur le long des bus de collecte des cellules puis à effectuer une réticulation de la colle située entre les fils conducteurs et les bus de collecte. Ainsi, la colle comprend des particules d'argent pour être électriquement compatible avec le revêtement des fils conducteurs. Mais le procédé nécessite un équipement de sérigraphie supplémentaire pour déposer la colle conductrice ce qui rend le procédé complexe à mettre en oeuvre. Par ailleurs, ce procédé de fabrication nécessite également une grande quantité d'argent. Il est donc particulièrement coûteux.

On peut en outre citer la demande de brevet européen EP 3 165 361 qui divulgue un procédé d'interconnexion entre des cellules photovoltaïques bifaciales utilisant une feuille polymère adhésive comprenant des fils conducteurs. Ce procédé est habituellement désigné par la marque commerciale SmartWire Connection Technology^{™} (SWCT). La feuille polymère est discontinue, et comprend des portions supérieures destinées à être placées au contact des faces supérieures de certaines cellules et des portions inférieures destinées à être placées au contact des faces inférieures d'autres cellules. Entre deux portions de feuilles, les fils conducteurs sont libres. La brasure des fils de cuivre étamés est réalisée pendant une étape de lamination à une température comprise entre 160 et 170°C. On entend par lamination, une étape qui consiste à chauffer des éléments maintenus ensemble, en générale par pression, de manière à les souder entre eux. Cette méthode présente pour inconvénient d'induire un coût relativement élevé, notamment en termes de matériaux utilisés. L'alliage métallique recouvrant les fils de cuivre doit être composé de Bi afin de baisser sa température de fusion sous les 150°C. En outre ce procédé nécessite l'utilisation de deux équipements pour réaliser les interconnexions entre cellules, un équipement de réalisation des fils de cuivres tenus par la feuille polymère et un équipement permettant de réaliser l'assemblage des fils avec les cellules.

Un objet de la présente invention est donc de proposer une solution pour interconnecter des cellules photovoltaïques en limitant les inconvénients mentionnés ci-avant. En particulier, il existe un besoin consistant à proposer un procédé d'interconnexion de cellules photovoltaïques simple à mettre en oeuvre, tout en permettant de réduire les coûts de fabrication.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, il est proposé un procédé de fabrication d'une chaîne d'au moins deux cellules photovoltaïques électriquement interconnectées, comprenant :
- une fourniture d'une courroie de transport déplaçable en translation selon une direction principale ; et
- une élaboration d'une chaîne d'au moins une première et une deuxième cellules photovoltaïques, chaque cellule comprenant une première structure électriquement conductrice d'une première polarité et une deuxième structure électriquement conductrice d'une deuxième polarité, l'élaboration comprenant :
- un placement des première et deuxième cellules sur la courroie de transport ; et
- un dépôt, sur l'un parmi la courroie de transport et les première et deuxième cellules, d'au moins un élément d'interconnexion destiné à être couplé électriquement à la deuxième structure de la première cellule et à la première structure de la deuxième cellule.

L'élaboration comprend, pour chaque cellule :
- un déploiement d'au moins un élément adhésif à partir d'une source d'élément adhésif, le déploiement étant effectué selon une direction secondaire inclinée par rapport à la direction principale en vue d'une mise en contact dudit au moins un élément adhésif avec ledit au moins un élément d'interconnexion et la cellule ;
- une découpe dudit au moins un élément adhésif pour le détacher de la source ;
- une mise en contact dudit au moins un élément adhésif avec ledit au moins un élément d'interconnexion et la cellule ; et
- un collage dudit au moins un élément adhésif sur ledit au moins un élément d'interconnexion et la cellule ;
l'élaboration comprenant en outre un couplage électrique dudit au moins un élément d'interconnexion à la deuxième structure de la première cellule et à la première structure de la deuxième cellule.

Ainsi, on fournit un procédé d'interconnexion de cellules qui est simple à mettre en oeuvre et qui permet de diminuer la quantité de matière d'élément adhésif utilisée. En outre, le procédé est particulièrement adapté pour tout type de cellules photovoltaïques, à savoir des cellules photovoltaïques ayant leurs structures électriquement conductrices situées sur leurs deux faces opposées, ou des cellules ayant leurs structures électriquement conductrices situées sur une même face. Avantageusement, un tel procédé permet d'améliorer le contact des éléments d'interconnexion avec les cellules de manière à éviter d'utiliser une étape de brasure des éléments d'interconnexion par un apport de métal pour réaliser le couplage électrique entre les éléments d'interconnexion et les structures électriquement conductrices des cellules. En outre, le procédé permet d'interconnecter des cellules sans busbars, ni plots d'argent, ni colles conductrices, ce qui limite davantage l'utilisation de matière métallique, et notamment d'argent.

Selon un autre aspect, il est proposé un procédé de fabrication d'un module photovoltaïque, comprenant au moins une chaîne d'au moins deux cellules photovoltaïques électriquement interconnectées selon le procédé de fabrication tel que défini ci-avant.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente schématiquement un mode de mise en oeuvre d'un procédé de fabrication d'une chaîne de cellules photovoltaïques ;
La figure 2 représente schématiquement un autre mode de mise en oeuvre d'un procédé de fabrication d'une chaîne de cellules photovoltaïques ;
Les figures 3 et 4 représentent schématiquement deux vues en coupe de différents types de cellules photovoltaïques ;
La figure 5 représente schématiquement une chaîne de cellules photovoltaïques d'un premier type ;
La figure 6 représente schématiquement une chaîne de cellules photovoltaïques d'un deuxième type ;
La figure 7 représente schématiquement un autre mode de mise en oeuvre d'un procédé de fabrication d'une chaîne de cellules photovoltaïques ; et
Les figures 8 et 9 représentent schématiquement deux vues d'autres modes de mise en oeuvre du procédé de fabrication de la chaîne de cellules photovoltaïques.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. Par exemple, les largeurs relatives des éléments d'interconnexion et des doigts de collecte ne sont pas représentatives de la réalité.

### DESCRIPTION DÉTAILLÉE

Avant d'entamer une revue détaillée de modes de réalisation et de mises en oeuvre de l'invention, sont énoncées ci-après des caractéristiques optionnelles qui peuvent éventuellement être utilisées en association ou alternativement.

Par exemple, le couplage électrique dudit au moins un élément d'interconnexion à la deuxième structure de la première cellule et à la première structure de la deuxième cellule est effectué sans brasure dudit au moins un élément d'interconnexion. Avantageusement, le collage d'au moins un élément adhésif sur au moins un élément d'interconnexion et sur chaque cellule permet une fixation mécanique des éléments d'interconnexion à la surface de la cellule pour permettre le couplage électrique sans apport supplémentaire de matière, en particulier de métal, généralement utilisé pour les étapes de brasure classiques de l'antérieur. Le collage des éléments adhésifs procure un maintien mécanique des éléments d'interconnexion sur les cellules. En d'autres termes, le couplage électrique peut être réalisé par la mise en contact et le maintien mécanique des éléments d'interconnexion à la surface de la cellule.

Par exemple, chaque cellule est dépourvue de bus de collecte.

Par exemple, la découpe est effectuée avant ou après la mise en contact.

Par exemple, le déploiement est effectué à partir d'un guide apte à tirer ledit au moins un élément adhésif en translation selon la direction secondaire.

Par exemple, ledit au moins un élément adhésif a des propriétés adhésives à température ambiante.

Par exemple, la source comprend au moins une bobine autour de laquelle est enroulé ledit au moins un élément adhésif.

Par exemple, on déploie, pour chaque déploiement, un nombre d'éléments adhésifs inférieur ou égal à six.

Par exemple, pour chaque cellule, la première structure est située sur une première face de la cellule, dite face inférieure, et la deuxième structure est située sur une deuxième face de la cellule, dite face supérieure, opposée à la première face.

Par exemple, le placement comprend un positionnement de la face inférieure de chaque cellule en regard de la courroie de transport, l'élaboration comprenant, une mise en contact d'au moins un premier élément adhésif avec ledit au moins un élément d'interconnexion et la face supérieure de la première cellule et une mise en contact d'au moins un deuxième élément adhésif avec ledit au moins un élément d'interconnexion, la face inférieure de la deuxième cellule et la courroie de transport.

Par exemple, le collage dudit au moins un premier élément adhésif est effectué en plaçant un élément chauffé à une température comprise entre 30° et 180°C, de préférence comprise entre 30°C et 150°C, au contact dudit au moins un premier élément adhésif.

Par exemple, le collage dudit au moins un deuxième élément adhésif comprend un chauffage de la courroie de transport à une température comprise entre 30° et 180°C, de préférence comprise entre 30°C et 150°C.

Par exemple, pour chaque cellule photovoltaïque, les première et deuxième structures sont situées sur une même face de la cellule, dite face arrière.

Par exemple, le placement comprend un positionnement de la face arrière de chaque cellule en regard de la courroie de transport, l'élaboration comprenant, pour chaque cellule, une mise en contact d'au moins un élément adhésif avec ledit au moins un élément d'interconnexion, la face arrière de la cellule et la courroie de transport.

Par exemple, le collage dudit au moins un élément adhésif comprend un chauffage de la courroie de transport à une température comprise entre 30° et 180°C, de préférence comprise entre 30°C et 150°C.

Par exemple, la courroie de transport est déplaçable en translation d'une première zone dans laquelle le placement est effectué vers une deuxième zone dans laquelle le collage est effectué, la deuxième zone étant située à distance de la première zone.

Par exemple, le chauffage de la courroie de transport est effectué progressivement par au moins deux paliers de températures croissants entre la première zone et la deuxième zone.

Par exemple, ledit au moins un élément adhésif ne comprend pas d'élément d'interconnexion.

Par exemple, le placement des première et deuxième cellules sur la courroie de transport est effectué de manière successive ou simultanée.

Par exemple, le couplage électrique comprend un dépôt d'un revêtement supérieur sur une première face de la chaîne et un dépôt d'un revêtement inférieur sur une deuxième face de la chaîne opposée à la première face, et une lamination par un apport de chaleur aux première et deuxième cellules. Avantageusement, les éléments adhésifs permettent de réaliser le couplage électrique sans apport de métal supplémentaire.

Il est précisé que dans le cadre de la présente invention, l'expression « A couplé à B » ou « A couplé électriquement à B » est synonyme de « A est en connexion électrique avec B » et ne signifie pas nécessairement qu'il n'existe pas d'organe entre A et B. Ainsi ces expressions s'entendent d'une connexion électrique entre deux éléments, cette connexion pouvant ou non être directe, cela signifie qu'il est possible qu'entre un premier dispositif A et un deuxième dispositif B qui sont électriquement connectés, un courant circule en A, en B, et sur le parcours reliant A à B, ce parcours pouvant ou non comprendre d'autres équipements électriques.

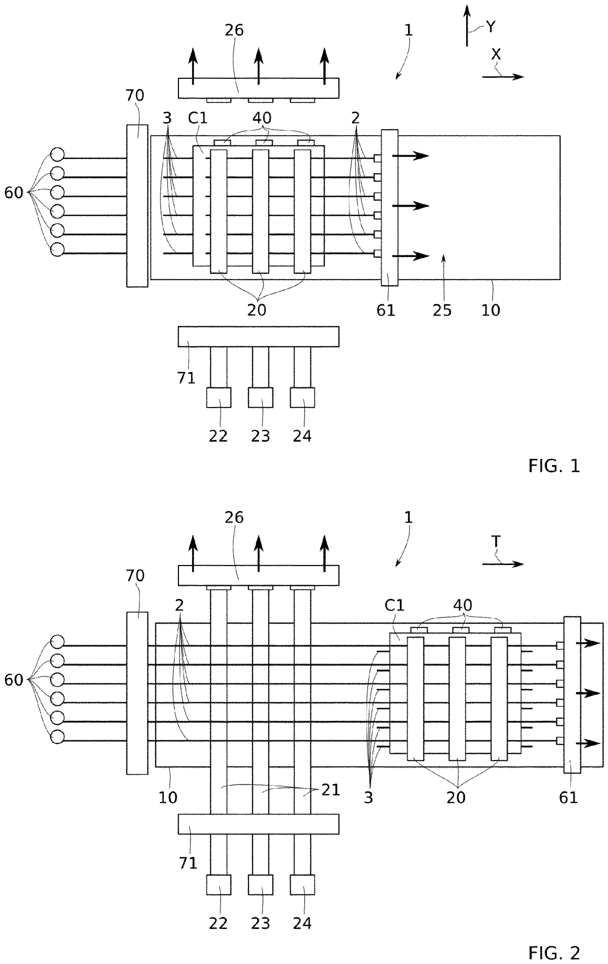

Sur les figures 1 à 9 ; on a représenté différentes étapes de différents modes de mise en oeuvre d'un procédé de fabrication d'une chaîne 1 d'au moins deux cellules photovoltaïques C1, C2. Les cellules photovoltaïques C1, C2 sont destinées à être électriquement interconnectées entre elles par l'intermédiaire d'éléments d'interconnexion 2, 3, 30 pour former une chaîne 1, appelée « chaîne photovoltaïque ». De façon générale, un module photovoltaïque 100 comprend un ensemble de cellules photovoltaïques C1, C2 interconnectées entre elles pour produire un courant. Avantageusement, dans le module photovoltaïque 100, les cellules photovoltaïques C1, C2 sont électriquement interconnectées entre elles et encapsulées dans un empilement de revêtements, les revêtements comprenant des matériaux du type polymère et/ou verre. L'empilement protège les cellules C1, C2 tout en conservant la fonction de conversion photoélectrique des cellules C1, C2.

De manière générale, une cellule photovoltaïque C1, C2 convertit une partie du rayonnement lumineux en énergie électrique. A cet effet une cellule photovoltaïque C1, C2 comporte un substrat, une première structure 4 électriquement conductrice d'une première polarité et une deuxième structure 5 électriquement conductrice d'une deuxième polarité. En particulier, la deuxième polarité est opposée à la première polarité. Le substrat est apte à produire des électrons lorsqu'il reçoit un rayonnement lumineux. On entend par un substrat, un film, une couche, « à base » d'un matériau, un substrat, un film, une couche comprenant ce matériau uniquement ou ce matériau et éventuellement d'autres matériaux, par exemple des éléments dopants. Le substrat comprend, par exemple, du silicium. En particulier, la première structure 4 forme un premier groupe d'électrodes d'une première polarité, et la deuxième structure 5 forme un deuxième groupe d'une ou de plusieurs électrodes d'une deuxième polarité. Les première et deuxième structures électriquement conductrices 4, 5 sont destinées à créer un champ électrique pour le déplacement des électrons au sein du substrat. En outre, la première structure électriquement conductrice 4 a pour rôle de collecter les électrons photo-générés par le substrat et la deuxième structure électriquement conductrice 5 a pour rôle de collecter le courant produit par le déplacement des électrons.

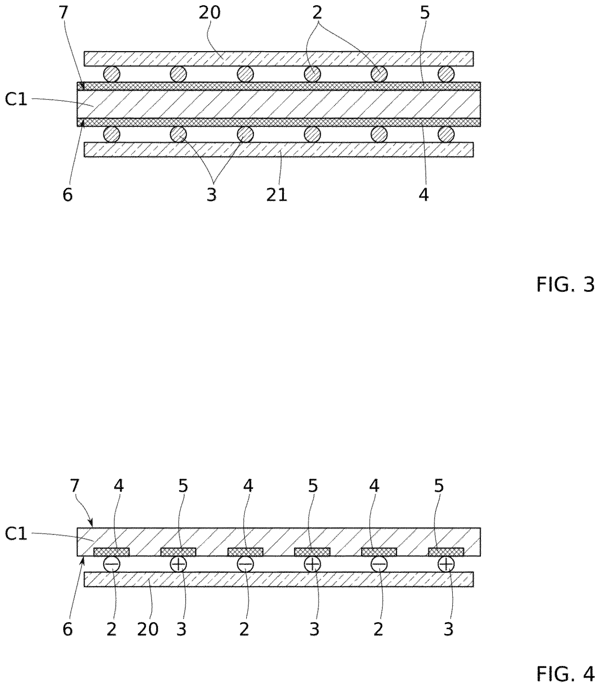

Les cellules C1, C2 peuvent être d'un premier type, dit standard, comme illustré sur la figure 3, pour lequel la première structure 4 est située sur une première face 6 de la cellule photovoltaïque C1, C2, dite face inférieure, et la deuxième structure 5 est située sur une deuxième face 7 de la cellule photovoltaïque C1, C2, dite face supérieure, opposée à la première face 6. Les cellules C1, C2 peuvent être d'un deuxième type, dit à contacts interdigités en face arrière (ou IBC, selon l'acronyme en langue anglaise, c'est-à-dire « Interdigitated Back Contact »), comme illustré sur la figure 4, pour lequel les première et deuxième structures 4, 5 sont situées sur une même face 6 de la cellule photovoltaïque C1, C2, dite face arrière. En outre, les cellules C1, C2 peuvent être bifaciales, c'est-à-dire que les première et deuxième faces 6, 7 de la cellule C1, C2 sont destinées à recevoir un rayonnement lumineux pour photo-générer un courant électrique sur chacune de ces faces 6, 7. Les cellules C1, C2 peuvent être mono-faciales, c'est-à-dire que seule l'une des deux faces 6, 7 de la cellule C1, C2 est apte à recevoir un rayonnement lumineux pour photo-générer un courant. On appelle également une face apte à recevoir un rayonnement lumineux pour photo-générer un courant, une face réceptrice. En particulier, les cellules C1, C2 du type IBC sont mono-faciales.

Les éléments d'interconnexion 2, 3, 30 sont destinés à interconnecter les cellules photovoltaïques C1, C2 entre elles. En particulier, les éléments d'interconnexion 2, 3, 30 ont pour rôle de transporter un courant, notamment à partir des électrons produits par le substrat de la cellule photovoltaïque C1, C2. Un élément d'interconnexion 2, 3, 30 peut être un fil ou un ruban. Un fil a une forme globalement cylindrique et a une longueur strictement supérieure à sa largeur. Au contraire, un ruban a une forme globalement parallélépipédique et a également une longueur strictement supérieure à sa largeur. Par exemple, un élément d'interconnexion 2, 3, 30 peut être un fil ayant un diamètre compris entre 100 et 350 micromètres. Un espacement entre deux fils peut être compris entre 2 et 15 mm. Selon un autre exemple, un élément d'interconnexion 2, 3, 30 peut être un ruban ayant une section comprise entre 0.1 mm de hauteur sur 0.3 mm de largeur et 0.3 mm de hauteur sur 1 mm de largeur (la largeur et la hauteur étant mesurées selon deux directions perpendiculaires entre elles et perpendiculaires à la direction principale X). L'espacement entre deux rubans peut être compris entre 5 et 35 mm.

Par exemple, les éléments d'interconnexion 2, 3, 30 comportent du cuivre. Avantageusement, les éléments d'interconnexion sont dits « étamés », c'est-à-dire que les éléments d'interconnexion 2, 3, 30 comprennent un revêtement anti-corrosion pour les rendre plus résistants à la corrosion de l'eau. Par exemple, le revêtement anti-corrosion peut comprendre de l'étain.

De manière générale, le procédé de fabrication de la chaîne 1 de cellules C1, C2, comprend une fourniture d'une courroie de transport 10 et une élaboration d'une chaîne 1 d'au moins une première et une deuxième cellules photovoltaïques C1, C2. La courroie de transport 10 est déplaçable en translation selon une direction principale X. L'élaboration comprend un placement des premières et deuxième cellules C1, C2 sur la courroie de transport 10 et un dépôt sur l'un parmi la courroie de transport 10 et les première et deuxième cellules C1, C2, d'au moins un élément d'interconnexion 2, 3, 30 destiné à être couplé électriquement à la deuxième structure 5 de la première cellule C1 et à la première structure 4 de la deuxième cellule C2. Le placement des première et deuxième cellules C1, C2 sur la courroie de transport 10 est effectué de manière successive ou simultanée. En particulier, lorsque les cellules C1, C2 sont placées successivement sur la courroie de transport 10, c'est-à-dire l'une après l'autre, on déplace la courroie de transport 10, par une translation T de la courroie de transport 10 d'un pas, après chaque placement d'une cellule C1, C2. On entend par placer un élément sur la courroie de transport 10, un positionnement de l'élément directement sur la courroie de transport 10, ou un positionnement de l'élément sur une pièce intermédiaire, la pièce intermédiaire pouvant être positionnée directement ou indirectement sur la courroie de transport 10. En outre, le pas peut correspondre à un déplacement de la courroie de transport 10 d'une longueur égale à la longueur d'une cellule C1, C2 à laquelle on ajoute la longueur séparant deux cellules C1, C2 consécutives, la longueur étant mesurée selon la direction principale X.

En particulier, le dépôt consiste à déployer au moins un élément d'interconnexion 2, 3, 30 à partir d'au moins une source d'élément d'interconnexion 60, le déploiement étant effectué selon la direction principale X en vue du couplage électrique entre un élément d'interconnexion 2, 3, 30 et l'une des structures 4, 5 des cellules C1, C2. Avantageusement, le déploiement des éléments d'interconnexion 2, 3, 30 s'étend dans un plan parallèle à un plan 25 de la courroie de transport 10. Le plan 25 est un plan dans lequel s'étend la courroie de transport 10. Par ailleurs, le dépôt comprend une découpe, par une unité de découpe principale 70, des éléments d'interconnexion 2, 3, 30 pour les détacher de la source d'élément d'interconnexion 60. Les éléments d'interconnexion 2, 3, 30 peuvent être reliés à une même source 60. De préférence, chaque élément d'interconnexion 2, 3, 30 est relié à une source d'élément d'interconnexion 60 distincte. Par exemple, une source d'élément d'interconnexion 60 comprend une bobine autour de laquelle est enroulé un ou plusieurs éléments d'interconnexion 2, 3, 30. Le déploiement des éléments d'interconnexion 2, 3, 30 peut être effectué à partir d'un guide principal 61 apte à tirer les éléments d'interconnexion 2, 3, 30 en translation selon la direction principale X. En particulier, après la découpe des éléments d'interconnexion 2, 3, 30, pour la première cellule C1, le guide principal 61 peut reprendre sa position initiale pour tirer d'autres éléments d'interconnexion 2, 3, 30 pour la deuxième cellule C2.

Par ailleurs, l'élaboration comprend, pour chaque cellule C1, C2, un déploiement d'au moins un élément adhésif 20, 21, 40, 41, une découpe, par une unité de découpe secondaire 71, de chaque élément adhésif 20, 21, 40, 41, une mise en contact de chaque élément adhésif 20, 21, 40, 41 avec les éléments d'interconnexion 2, 3, 30 et la cellule C1, C2 et un collage.

En particulier, le déploiement consiste à déployer au moins un élément adhésif 20, 21, 40, 41 à partir d'au moins une source d'élément adhésif 22 à 23, le déploiement étant effectué selon une direction secondaire Y inclinée par rapport à la direction principale X en vue de la mise en contact. Ainsi, il n'est pas nécessaire d'aligner les éléments adhésifs 20, 21, 40, 41 avec des busbars. Avantageusement, la direction secondaire Y s'étend dans un plan parallèle au plan 25 de la courroie de transport 10. De préférence, la direction secondaire Y est perpendiculaire à la direction principale X. Par ailleurs, la découpe consiste à détacher chaque élément adhésif 20, 21, 40, 41 de la source d'élément adhésif 22 à 24. Les éléments adhésifs 20, 21, 40, 41 peuvent être reliés à une même source 22 à 24. De préférence, chaque élément adhésif 20, 21, 40, 41 est relié à une source 22 à 24 distincte. Par exemple, une source 22 à 24 comprend une bobine autour de laquelle est enroulé un ou plusieurs éléments adhésifs 20, 21, 40, 41. La découpe peut être effectuée avant ou après la mise en contact. En outre, le collage consiste à coller les éléments adhésifs sur chaque élément d'interconnexion 2 et la cellule C1, C2. Le collage peut être effectué avant ou après la découpe. L'élaboration comprend en outre un couplage électrique des éléments élément d'interconnexion 2 à la deuxième structure 5 de la première cellule C1 et à la première structure 4 de la deuxième cellule C2. Ainsi, grâce au collage des éléments adhésifs 20, 21, 40, 41, on évite que le matériau d'un revêtement placé ultérieurement sur les faces 6, 7 des cellules C1, C2 vienne se placer entre les éléments d'interconnexion 2, 3, 30 et les structures électriquement conductrices 4, 5. Ainsi, le collage des éléments adhésifs 20, 21, 40, 41 améliore le couplage électrique.

Le déploiement peut être effectué à partir d'un guide secondaire 26 apte à tirer les éléments adhésifs 20, 21, 40, 41 en translation selon la direction secondaire Y. En particulier, après la découpe des premiers éléments adhésifs 20, pour la première cellule C1, le guide secondaire 26 peut reprendre sa position initiale pour tirer des deuxièmes éléments adhésifs 21, pour la deuxième cellule C2.

De préférence, un élément adhésif 20, 21, 40, 41 a une forme d'un ruban. Son épaisseur est variable, elle peut être comprise entre 20 et 200 micromètres.

Par exemple, un élément adhésif a des propriétés adhésives à température ambiante, c'est-à-dire une température proche de 25°C. En d'autres termes, un élément adhésif 20, 21, 40, 41 est collé à un élément d'interconnexion 2 lorsqu'il est mis en contact avec l'élément d'interconnexion 2. En variante, un élément adhésif 20, 21, 40, 41 peut être collé par un apport de température entraînant sa fusion. Par exemple un élément adhésif peut avoir une température de fusion comprise entre 130°C et 150°C. La température utilisée pour chauffer un élément adhésif 20, 21, 40, 41 est comprise entre 30° et 180°C, de préférence comprise entre 30°C et 150°C, et par exemple comprise entre 140°C et 160°C. En d'autres termes, un élément adhésif 20, 21, 40, 41, lorsqu'il est collé, couple mécaniquement un élément d'interconnexion 2, 3 à une cellule C1, C2.

Par exemple, un élément adhésif 20, 21, 40, 41 peut être réalisé à partir de polyoléfine, de préférence de polyéthylène. Ainsi, le collage évite d'avoir à maintenir les éléments adhésifs en contact avec les cellules, ce qui simplifie la mise en oeuvre du procédé.

Avantageusement, un élément adhésif 20, 21, 40, 41 est transparent à la lumière de façon à limiter un effet d'ombrage sur la cellule photovoltaïque C1, C2 qui pourrait diminuer sa production de courant. On entend par lumière, un rayonnement électromagnétique dont la longueur d'onde est comprise entre 300 et 1200 nm. En outre, on entend par transparent à la lumière, un élément adhésif 20, 21, 40, 41 qui permet de transmettre au moins 90 % d'un flux de lumière. Par exemple un élément adhésif 20, 21, 40, 41 comprend un taux de transmission de lumière (ayant une longueur d'onde comprise entre 300 et 1200 nm) de 90%. Par exemple, un élément adhésif 20, 21, 40, 41 peut avoir un coefficient d'absorption strictement inférieur à 100 m⁻¹ sur une plage de longueur d'onde comprise entre 300 et 1200 nm. Par exemple, un élément adhésif 20, 21, 40, 41 peut avoir un indice de réfraction n = 1, 5 ± 0.03 pour une longueur d'onde comprise entre 300 et 1200 nm (l'indice de réfraction n étant sans unité). Selon un autre avantage, un élément adhésif 20, 21, 40, 41 peut être hydrophobe. Par exemple un tel élément adhésif 20, 21, 40, 41 peut avoir un taux d'absorption d'eau de 0.35 % (à 48 heures) et un taux d'absorption d'eau de 1.5 % (à saturation).

Un élément adhésif 20, 21, 40, 41 peut également posséder une propriété d'adhésion sur une cellule C1, C2 > 1 N/mm. Un élément adhésif 20, 21, 40, 41 peut posséder une propriété d'adhésion sur un élément d'interconnexion > 1 N/mm.

L'élément adhésif 20, 21, 40, 41 peut, en outre, comprendre un module d'élasticité égal à 1210 Mpa, une contrainte à la rupture égale à 24 Mpa et un allongement à la rupture de 7%.

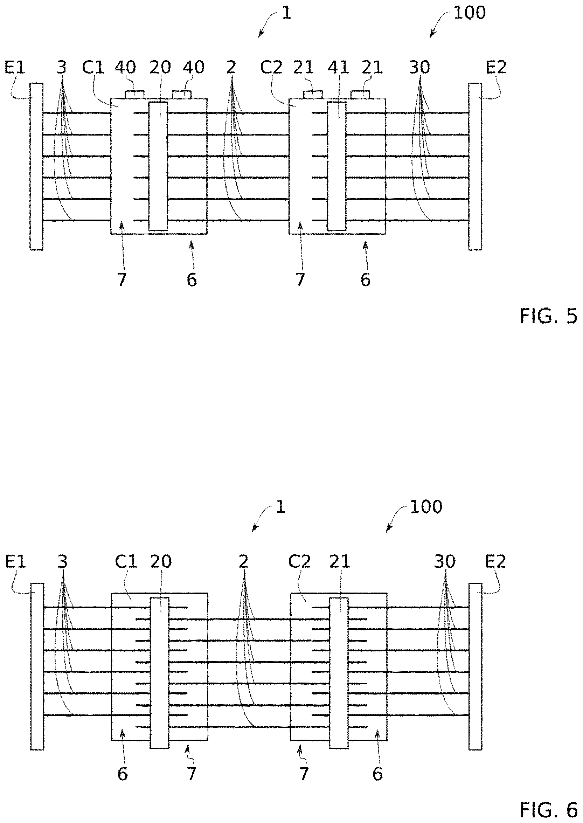

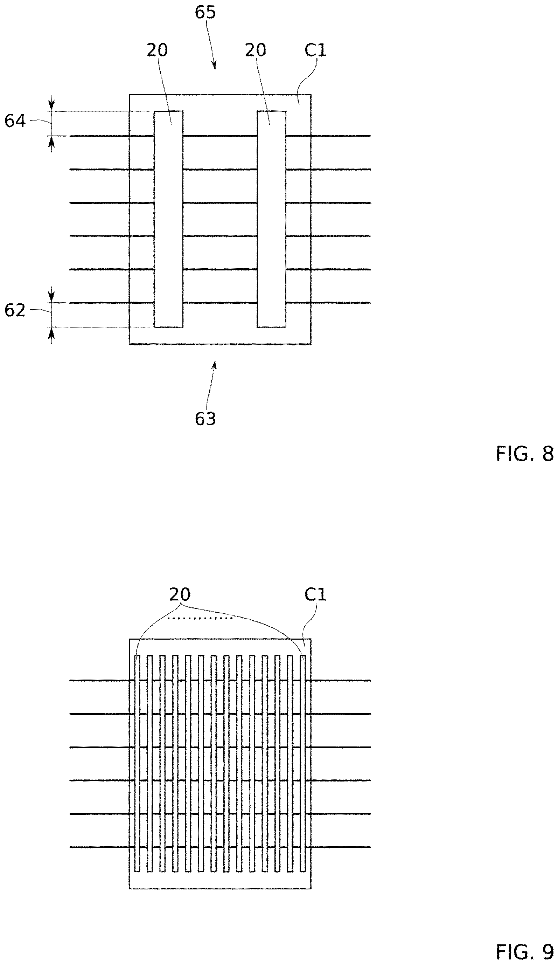

En outre, des éléments adhésifs 20, 21 peuvent être collés sur une seule face 6 d'une cellule C1, C2 du deuxième type, comme illustré sur la figure 6, ou des éléments adhésifs 20, 21, 40, 41 peuvent être collés sur les deux faces 6, 7 d'une cellule C1, C2 du premier type, comme illustré sur la figure 5. De façon générale, pour chaque cellule C1, C2, on déploie au moins deux éléments adhésifs 20, 21, 40, 41 pour chaque face 6, 7 mise en contact avec un élément d'interconnexion 2, 3, 30, afin d'améliorer le contact de l'élément d'interconnexion 2, 3, 30 avec la face 6, 7. Les éléments adhésifs 20, 21, 40, 41 peuvent se toucher, ou être distant de 0.5 à plusieurs mm en fonction de la taille de la cellule C1, C2. Comme illustré sur la figure 8, on a représenté une cellule C1 ayant une face supérieure 7 pour laquelle on a déployé deux éléments adhésifs 20. Selon un autre exemple illustré sur la figure 9, on a représenté une cellule C1 ayant une largeur d'environ 78 mm, et plus précisément égale à 78.375 mm, (la largeur de la cellule C1 étant mesurée selon la direction principale X) et ayant une face supérieure 7 pour laquelle on a déployé quatorze éléments adhésifs 20 ayant chacun une largeur de 5 mm et espacés de 0,56 mm. La largeur d'un élément adhésif 20, 21, 40, 41, mesurée selon la direction principale X, dépend du nombre d'élément adhésif déployé afin de diminuer au mieux la surface d'élément adhésif utilisée qui recouvre la face 6, 7 de la cellule C1, C2. Par exemple, la largeur d'un élément adhésif 20, 21, 40, 41 peut être comprise entre 5 et 20 mm. En outre, la longueur d'un élément adhésif 20, 21, 40, 41 dépend de la longueur des cellules C1, C2. De préférence, un élément adhésif 20, 21, 40, 41 est découpé de façon que lorsqu'il est mis en contact avec un élément d'interconnexion 2, 3, 30, sa longueur dépasse les éléments d'interconnexion 2, 3, 30, comme illustré sur la figure 8. Par exemple, la longueur d'un élément adhésif 20, 21, 40, 41 dépasse d'une première longueur 62 un élément d'interconnexion 2, 3, 30 situé au niveau d'une première extrémité 63 d'une cellule C1, C2 et dépasse d'une deuxième longueur 64 un élément d'interconnexion 2, 3, 30 situé au niveau d'une deuxième extrémité 65 de la cellule C1, C2. Les première et deuxième longueurs 62, 64 peuvent être supérieures ou égales à 5 mm.

Selon un autre avantage, le procédé peut comprendre une mise en contact d'un élément adhésif intermédiaire, non représenté à des fins de simplification, avec au moins un élément d'interconnexion 2, 3, 30 et les première et deuxième cellules C1, C2. Par exemple, l'élément adhésif intermédiaire peut être mis en contact avec les faces supérieures 7, ou avec les faces inférieures 6, des deux cellules C1, C2.

Par ailleurs, les cellules du premier type peuvent comprendre une ou deux faces réceptrices, c'est-à-dire une face destinée à recevoir le rayonnement de lumière. Les éléments adhésifs 20, 21, 40, 41 absorbent une partie du rayonnement et limitent les performances photoélectriques de la cellule C1, C2.

Ainsi, de préférence, pour chaque cellule C1, C2, on déploie un nombre d'éléments adhésifs 20, 21, 40, 41 inférieur ou égal à six afin de limiter au maximum l'absorption du rayonnement tout en maximisant la tenue mécanique des éléments d'interconnexion sur les cellules C1, C2. Par ailleurs, les éléments adhésifs 20 ,21 ne comprennent pas d'élément d'interconnexion, notamment pour encore mieux limiter l'absorption du rayonnement de lumière. En particulier, les bobines des sources d'éléments adhésifs 20, 21, 40, 41 ne comprennent pas d'élément d'interconnexion.

La découpe des éléments d'interconnexion 2, 3, 30 peut être effectuée avant ou après la mise en contact. En effet, on peut placer sur la courroie de transport un élément adhésif 20, 21, 40, 41 puis un élément d'interconnexion 2, 3, 30. Selon un autre exemple, on peut placer un élément d'interconnexion 2, 3, 30 sur une face 6, 7 d'une cellule C1, C2, puis un élément adhésif 20, 21, 40, 41 sur l'élément d'interconnexion et la face 6, 7 de la cellule C1, C2.

Le procédé permet de fabriquer une chaîne 1 comprenant uniquement deux cellules C1, C2 ou plusieurs cellules. De façon générale, une chaîne 1 est destinée à être couplée à deux électrodes E1, E2, comme illustré sur les figures 5 et 6, pour un raccordement électrique à un équipement électrique extérieur ou à une autre chaîne 1.

Avantageusement, l'élaboration comprend un dépôt d'au moins un premier élément d'interconnexion 3 destiné à être couplé électriquement à la première structure 4 de la première cellule C1 et à la deuxième structure 5 d'une autre cellule de la chaîne 1 ou à une première électrode E1. L'élaboration comprend en outre un dépôt d'au moins un deuxième élément d'interconnexion 2 destiné à être couplé électriquement à la deuxième structure 5 de la première cellule C1 et à la première structure 4 de la deuxième cellule C2. En outre, l'élaboration peut comprendre un dépôt d'au moins un troisième élément d'interconnexion 30 destiné à être couplé électriquement à la deuxième structure 5 de la deuxième cellule C2 et à la première structure 4 d'une autre cellule de la chaîne ou à une deuxième électrode E2.

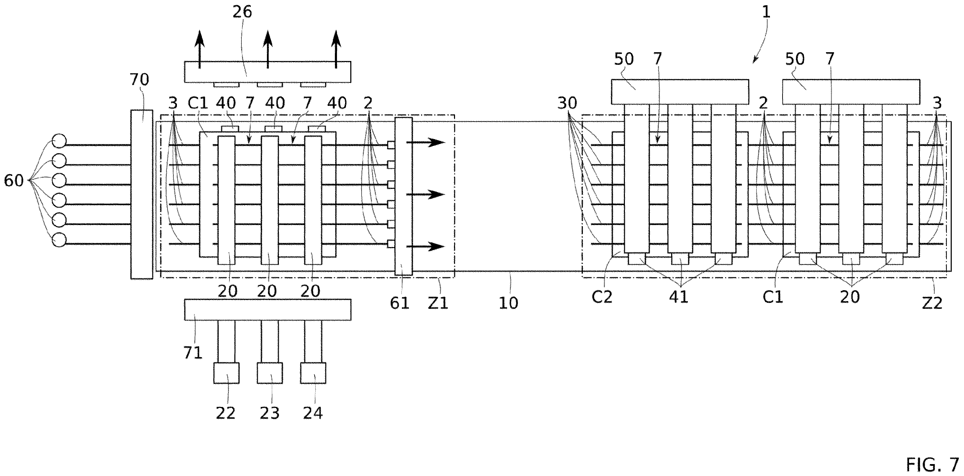

On a représenté sur les figures 1, 2, 5 et 7, les principales étapes d'un procédé de fabrication d'une chaîne de deux cellules C1, C2 du premier type. Plus particulièrement, on a représenté sur les figures 5 et 7, une chaîne de cellules C1, C2 du premier type obtenue par le procédé tel que défini ci-avant. Pour le premier type de cellules C1, C2, le procédé comprend un placement des cellules C1, C2 dans lequel on positionne la face inférieure 6 de chaque cellule C1, C2 en regard de la courroie de transport 10, et l'élaboration comprend, une mise en contact d'au moins un premier élément adhésif 20 avec les deuxièmes éléments d'interconnexion 2 et la face supérieure 7 de la première cellule C1 et une mise en contact d'au moins un deuxième élément adhésif 21 avec les deuxièmes éléments d'interconnexion 2, la face inférieure 6 de la deuxième cellule C2 et la courroie de transport 10. Avantageusement, l'élaboration comprend une mise en contact d'au moins un troisième élément adhésif 40 avec les premiers éléments d'interconnexion 3, la face inférieure 6 de la première cellule C1 et la courroie de transport 10 et une mise en contact d'au moins un quatrième élément adhésif 41 avec les troisièmes éléments d'interconnexion 30 et la face supérieure 7 de la deuxième cellule C2.

Par exemple, pour des cellules C1, C2 du premier type, le procédé peut comprendre les étapes dans l'ordre successif suivant : une mise en contact de premiers éléments adhésifs 40 avec la courroie de transport 10, un dépôt de premiers éléments d'interconnexion 3 sur les premiers éléments adhésifs 40, un placement d'une première cellule C1 sur les premiers éléments adhésifs 40 et d'interconnexion 3, un dépôt de deuxièmes éléments d'interconnexion 2 sur la première cellule C1, en particulier sur sa face supérieure 7, une mise en contact de deuxièmes éléments adhésifs 20 avec les deuxièmes éléments d'interconnexion 2, une découpe des premiers éléments d'interconnexion 3, un déplacement de la courroie de transport 10 d'un pas, puis on réitère les étapes précédentes pour la deuxième cellule C2. En d'autres termes le procédé comprend une mise en contact de troisièmes éléments adhésifs 21 avec la courroie de transport 10, un déploiement et un dépôt des deuxièmes éléments d'interconnexion 2 sur les troisièmes éléments adhésifs 21, un placement d'une deuxième cellule C2 sur les troisièmes éléments adhésifs 21 et les deuxièmes éléments d'interconnexion 2, un dépôt de troisièmes éléments d'interconnexion 30 sur la deuxième cellule C2, en particulier sur sa face supérieure 7, une mise en contact de quatrièmes éléments adhésifs 41 avec les troisièmes éléments d'interconnexion 30, et une découpe des deuxièmes éléments d'interconnexion 2.

En outre, on a représenté sur la figure 7, un exemple dans lequel le collage des éléments adhésifs 20, 41 mis en contact avec les faces supérieures 7 des cellules C1, C2 est effectué en plaçant un élément 50 chauffé à une température comprise entre 30° et 180°C, de préférence comprise entre 30°C et 150°C, au contact des éléments adhésifs 20, 41. On peut placer un élément 50 chauffé, par exemple un tampon en mousse, au contact d'un élément adhésif 20, 21, 40, 41 en exerçant une pression. Le temps de pression peut être court, par exemple de 1 s. Par ailleurs, le collage des éléments adhésifs 21, 40 mis en contact avec la courroie de transport 10 peut comprendre un chauffage de la courroie de transport 10 à une température comprise entre 30° et 180°C, de préférence comprise entre 30°C et 150°C. Avantageusement, un collage effectué à une température comprise entre 30°C et 130°C permet d'interconnecter des cellules C1, C2 qui ne résistent pas des températures strictement supérieures à 130°C. Par exemple, on peut facilement interconnecter des cellules C1, C2 à hétérojonction.

Par exemple, comme illustré sur la figure 6, pour des cellules C1, C2 du deuxième type, le procédé peut comprendre les étapes dans l'ordre successif suivant :une mise en contact de premiers éléments adhésifs 20 avec la courroie de transport 10, un dépôt de premiers éléments d'interconnexion 3 sur les premiers éléments adhésifs 20, une découpe des premiers éléments d'interconnexion 3, un dépôt de deuxièmes éléments d'interconnexion 2 sur les premiers éléments adhésifs 20, un placement d'une première cellule C1 sur les premiers éléments adhésifs 20 et les premiers et deuxièmes éléments d'interconnexion 3, 2, un déploiement des deuxièmes éléments d'interconnexion 2 et un déplacement, par une translation T, de la courroie de transport 10 d'un pas, puis on réitère les étapes précédentes pour la deuxième cellule C2. En d'autres termes le procédé comprend une mise en contact de deuxièmes éléments adhésifs 21 avec la courroie de transport 10, un dépôt des deuxièmes éléments d'interconnexion 2 sur les deuxièmes éléments adhésifs 21, un dépôt et une découpe de troisièmes éléments d'interconnexion 30 sur les deuxièmes éléments adhésifs 21, et un placement d'une deuxième cellule C2 sur les deuxièmes éléments adhésifs 21 et les deuxièmes et troisièmes éléments d'interconnexion 2, 30.

Par ailleurs, comme illustré sur la figure 7, la courroie de transport 10 peut être déplaçable en translation d'une première zone Z1 dans laquelle le placement est effectué vers une deuxième zone Z2 dans laquelle le collage est effectué, la deuxième zone Z2 étant située à distance de la première zone Z1. Avantageusement, le chauffage de la courroie de transport 10 est effectué progressivement par au moins deux paliers de températures croissants entre la première zone et la deuxième zone. Par exemple, le chauffage comprend trois paliers dont les températures sont respectivement, 60°C, 80°C et 130°C. Selon un autre exemple, le chauffage comprend plusieurs paliers dont les températures sont respectivement, 30°C, 60°C, 80°C, 120°C ; 130°C et 150°C. Par exemple, avant d'arriver dans la deuxième zone Z2 de collage, une montée progressive de la température de la courroie est effectuée pour permettre aux différents matériaux d'avoir une montée en température progressive et moins destructrice. On note que le chauffage, par l'intermédiaire de la courroie de transport 10 ou de l'élément 50 chauffé, permet le collage et ne réalise pas une soudure ou une brasure des éléments d'interconnexion 2, 3, 30.

On a représenté sur la figure 6, un autre mode de mise en oeuvre du procédé de fabrication d'une chaîne de cellules C1, C2 pour lequel les cellules C1, C2 sont du deuxième type. Dans cet autre mode de mise en oeuvre, le procédé comprend un placement des cellules C1, C2 dans lequel on positionne la face arrière 6 de chaque cellule C1, C2 en regard de la courroie de transport 10, et l'élaboration comprend, pour chaque cellule C1, C2, une mise en contact d'au moins un élément adhésif 20, 21avec les deuxièmes éléments d'interconnexion 2, la face arrière 6 de la cellule C1, C2 et la courroie de transport 10. En outre, l'élaboration comprend une mise en contact d'au moins un premier élément adhésif 20 avec les premiers éléments d'interconnexion 3 et une mise en contact d'au moins un deuxième élément adhésif 21 avec les troisièmes éléments d'interconnexion 30. Avantageusement, le collage des éléments adhésifs 20, 21 mis en contact avec la courroie de transport 10 peut comprendre un chauffage de la courroie de transport 10 à une température supérieure ou égale à 120°C. En variante, on peut positionner les faces supérieures 7 des cellules C1, C2 en regard de la courroie de transport 10, déposer les éléments d'interconnexion 2, 3, 30 sur les faces inférieures 6 des cellules C1, C2, mettre les éléments adhésifs 20, 21en contact avec les faces inférieures 6 et coller les éléments adhésifs 20, 21 en plaçant l'élément 50 chauffé à une température supérieure ou égale à 120°C au contact des éléments adhésifs 20, 21.

Le couplage électrique peut en outre comprendre un dépôt d'un revêtement supérieur sur une première face de la chaîne 1 et un dépôt d'un revêtement inférieur sur une deuxième face de la chaîne 1, opposée à la première face, et une lamination par un apport de chaleur aux première et deuxième cellules C1, C2. Au cours de la lamination, le couplage électrique est effectué sans apport de métal supplémentaire, c'est-à-dire sans soudure. Ainsi, la fabrication d'un module photovoltaïque, comprend au moins une chaîne 1 d'au moins deux cellules photovoltaïques C1, C2 électriquement interconnectées selon le procédé de fabrication tel que défini ci-avant. En outre, le procédé qui vient d'être décrit ne comporte pas une étape de soudure entre les éléments d'interconnexion et les structures électriquement conductrices des cellules, ce qui limite les contraintes mécaniques sur les cellules. Un autre avantage permet, après utilisation des chaînes de cellules de séparer les différents éléments qui la compose pour un recyclage plus facile des éléments constitutifs de la chaîne.

## Revendications

1. Procédé de fabrication d'une chaîne d'au moins deux cellules (C1, C2) photovoltaïques électriquement interconnectées, comprenant :
- une fourniture d'une courroie de transport (10) déplaçable en translation selon une direction principale ; et
- une élaboration d'une chaîne d'au moins une première et une deuxième cellules photovoltaïques (C1, C2), chaque cellule (C1, C2) comprenant une première structure électriquement conductrice d'une première polarité et une deuxième structure électriquement conductrice d'une deuxième polarité, l'élaboration comprenant :
- un placement des première et deuxième cellules (C1, C2) sur la courroie de transport (10); et
- un dépôt, sur l'un parmi la courroie de transport (10) et les première et deuxième cellules (C1, C2), d'au moins un élément d'interconnexion (2, 3, 30) destiné à être couplé électriquement à la deuxième structure de la première cellule (C1) et à la première structure de la deuxième cellule (C2) ;
l'élaboration comprenant, pour chaque cellule (C1, C2) :
- un déploiement d'au moins un élément adhésif (20, 21, 40, 41) à partir d'une source d'élément adhésif, le déploiement étant effectué selon une direction secondaire inclinée par rapport à la direction principale en vue d'une mise en contact dudit au moins un élément adhésif (20, 21, 40, 41) avec ledit au moins un élément d'interconnexion (2, 3, 30) et la cellule (C1, C2) ;
- une découpe dudit au moins un élément adhésif (20, 21, 40, 41) pour le détacher de la source ;
- une mise en contact dudit au moins un élément adhésif (20, 21, 40, 41) avec ledit au moins un élément d'interconnexion (2, 3, 30) et la cellule (C1, C2) ; et
- un collage dudit au moins un élément adhésif (20, 21, 40, 41) sur ledit au moins un élément d'interconnexion (2, 3, 30) et la cellule (C1, C2) ;
- l'élaboration comprenant en outre un couplage électrique dudit au moins un élément d'interconnexion (2, 3, 30) à la deuxième structure de la première cellule (C1) et à la première structure de la deuxième cellule (C2) ;
**caractérisé en ce que** le couplage électrique dudit au moins un élément d'interconnexion (2, 3, 30) à la deuxième structure de la première cellule (C1) et à la première structure de la deuxième cellule (C2) est effectué sans brasure dudit au moins un élément d'interconnexion (2, 3, 30).

2. Procédé selon la revendication précédente, dans lequel ledit au moins un élément adhésif (20, 21, 40, 41) a des propriétés adhésives à température ambiante.

3. Procédé selon l'une quelconque des revendications précédentes, dans lequel, pour chaque cellule (C1, C2), la première structure est située sur une première face de la cellule (C1, C2), dite face inférieure, et la deuxième structure est située sur une deuxième face de la cellule (C1, C2), dite face supérieure, opposée à la première face.

4. Procédé selon la revendication précédente, dans lequel, le placement comprend un positionnement de la face inférieure de chaque cellule (C1, C2) en regard de la courroie de transport (10), l'élaboration comprenant, une mise en contact d'au moins un premier élément adhésif (20) avec ledit au moins un élément d'interconnexion (2, 3, 30) et la face supérieure de la première cellule (C1) et une mise en contact d'au moins un deuxième élément adhésif (21) avec ledit au moins un élément d'interconnexion (2, 3, 30), la face inférieure de la deuxième cellule (C2) et la courroie de transport (10).

5. Procédé selon la revendication précédente, dans lequel le collage dudit au moins un premier élément adhésif (20) est effectué en plaçant un élément chauffé à une température comprise entre 30° et 180°C, de préférence comprise entre 30°C et 150°C, au contact dudit au moins un premier élément adhésif (20).

6. Procédé selon l'une quelconque des revendications 4 ou 5, dans lequel le collage dudit au moins un deuxième élément adhésif (21) comprend un chauffage de la courroie de transport (10) à une température comprise entre 30° et 180°C, de préférence comprise entre 30°C et 150°C.

7. Procédé selon l'une quelconque des revendications 1 à 2, dans lequel, pour chaque cellule (C1, C2), les première et deuxième structures sont situées sur une même face de la cellule (C1, C2), dite face arrière.

8. Procédé selon la revendication précédente, dans lequel, le placement comprend un positionnement de la face arrière de chaque cellule (C1, C2) en regard de la courroie de transport (10), l'élaboration comprenant, pour chaque cellule (C1, C2), une mise en contact d'au moins un élément adhésif (20, 21) avec ledit au moins un élément d'interconnexion (2, 3, 30), la face arrière de la cellule (C1, C2) et la courroie de transport (10).

9. Procédé selon la revendication précédente, dans lequel le collage dudit au moins un élément adhésif (20, 21) comprend un chauffage de la courroie de transport (10) à une température comprise entre 30° et 180°C, de préférence comprise entre 30°C et 150°C.

10. Procédé selon l'une quelconque des revendications 6 ou 9, dans lequel la courroie de transport (10) est déplaçable en translation d'une première zone dans laquelle le placement est effectué vers une deuxième zone dans laquelle le collage est effectué, la deuxième zone étant située à distance de la première zone.

11. Procédé selon la revendication précédente, dans lequel le chauffage de la courroie de transport (10) est effectué progressivement par au moins deux paliers de températures croissants entre la première zone et la deuxième zone.

12. Procédé selon l'une quelconque des revendications précédentes, dans lequel le placement des première et deuxième cellules (C1, C2) sur la courroie de transport (10) est effectué de manière successive ou simultanée.

13. Procédé selon l'une quelconque des revendications précédentes, dans lequel le couplage électrique comprend un dépôt d'un revêtement supérieur sur une première face de la chaîne et un dépôt d'un revêtement inférieur sur une deuxième face de la chaîne opposée à la première face, et une lamination par un apport de chaleur aux première et deuxième cellules (C1, C2).

14. Procédé selon l'une quelconque des revendications précédentes, dans lequel chaque cellule (C1, C2) est dépourvue de bus de collecte.

15. Procédé de fabrication d'un module photovoltaïque, comprenant au moins une chaîne d'au moins deux cellules photovoltaïques (C1, C2) électriquement interconnectées selon le procédé de fabrication selon l'une quelconque des revendications précédentes.
